(19) Europäisches Patentamt
European Patent Office
Office européen des brevets

(11) **EP 4 761 481 A1**

(12) **EUROPÄISCHE PATENTANMELDUNG**

(43) Veröffentlichungstag:
17.06.2026 Patentblatt 2026/25

(21) Anmeldenummer: 25222451.4

(22) Anmeldetag: 11.12.2025

(51) Internationale Patentklassifikation (IPC):
*H05K 7/16* (2006.01)

(52) Gemeinsame Patentklassifikation (CPC):
**H05K 7/16**; H02B 1/36

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: **13.12.2024 DE 102024137625**

(71) Anmelder: **Jovyatlas GmbH**
**26844 Jemgum (DE)**

(72) Erfinder:
• **Lüttmer, Wiebe**
**26844 c/o JOVYATLAS GmbH, Jemgum,**
**Deutschland (DE)**
• **Temmen, Martin**
**26844 c/o JOVYATLAS GmbH, Jemgum,**
**Deutschland (DE)**
• **Straub, Alexander**
**26844 c/o JOVYATLAS GmbH, Jemgum,**
**Deutschland (DE)**

(74) Vertreter: **Grättinger Möhring von Poschinger**
**Patentanwälte Partnerschaft mbB**
**Wittelsbacherstrasse 2b**
**82319 Starnberg (DE)**

(54) **SCHALTSCHRANK ZUR AUFNAHME EINES EINBAUMODULS**

(57) Die vorliegende Erfindung betrifft einen Schaltschrank (1) zur Aufnahme eines Einbaumoduls (19) umfassend einen Schrankrahmen (8), der von einer frontseitigen Rahmenebene (12) begrenzt ist, eine fest mit dem Schrankrahmen (8) verbundene Schienenanordnung (5) und eine zur Aufnahme des Einbaumoduls geeignete Schwenkvorrichtung (2) mit Führungselementen (3.1, 3.2), die entlang der Schienenanordnung (5) verschiebbar sind. Die Schwenkvorrichtung (2) ist in einem eingeschwenkten Zustand vollständig in den Schrankrahmen (8) eingeschwenkt und durch Schwenken in einem ausgeschwenkten Zustand bringbar, in dem die Schwenkvorrichtung (2) teilweise durch die frontseitige Rahmenebene (12) aus dem Schrankrahmen (8) herausragt. Die Schienenanordnung (5) weist einen horizontal verlaufenden Tragschienenabschnitt (4) und einen oberhalb des Tragschienenabschnitts (4) angeordneten, diagonal verlaufenden Führungsschienenabschnitt (6) auf. Beim Schwenken der Schwenkvorrichtung (2) vom eingeschwenkten in den ausgeschwenkten Zustand verschiebt sich ein erstes der Führungselemente (3.1) der Schwenkvorrichtung (2) entlang des horizontal verlaufenden Tragschienenabschnitts (4) und verschiebt sich ein zweites der Führungselemente (3.2) der Schwenkvorrichtung (4) entlang des diagonal verlaufenden Führungsschienenabschnitts (6).

**Fig. 1**

EP 4 761 481 A1

**Beschreibung**

Die vorliegende Erfindung betrifft einen Schaltschrank zur Aufnahme eines (elektronischen oder elektrischen) Einbaumoduls mit einem Schrankrahmen und einer im Schrankrahmen schwenkbar gelagerten zur Aufnahme des Einbaumoduls geeigneten Schwenkvorrichtung.

Derartige Schaltschränke (auch Systemschränke, Racks oder Serverschränke genannt) dienen zur Aufnahme von einem oder mehreren Einbaumodulen, um diese vor mechanischen Einflüssen, Staub, Feuchtigkeit, elektromagnetischen Störungen und/oder unerlaubtem physischen Zugriff zu schützen. Abhängig vom jeweiligen Einsatzzweck kann ein aufgenommenes Einbaumodul beispielsweise als Steuergerät, Verteiler, Computer, Server, Gleichrichter, Wechselrichter oder Batteriemodul ausgeführt sein.

Einbaumodule werden dabei auch als Einschubmodule, Einschübe oder Baugruppenträger bezeichnet.

Um die Kompatibilität von Einbaumodulen und Schaltschränken unterschiedlicher Hersteller zu gewährleisten, existieren Normen, in denen die Abmessungen bzw. der mechanische Aufbau der einzelnen Komponenten definiert werden.

In der Normreihe DIN EN 60297 wird beispielsweise der mechanische Aufbau des sogenannten 19-Zoll-Systems definiert. Ein normgemäßes Einbaumodul weist dabei eine Frontplatte mit einer Breite von 19-Zoll auf, was 482,6 mm entspricht. Die Modulhöhe sowie die Modultiefe werden ebenfalls definiert.

Um die Zugänglichkeit der Einbaumodule bei Installations- bzw. Wartungsarbeiten zu verbessern, sind die Einbaumodule bei manchen Schaltschränken mittels Schwenkvorrichtungen schwenkbar im Schaltschrank gelagert.

Der Installateur (Monteur) kann auf diese Weise das Einbaumodul während Installations- bzw. Wartungsarbeiten zumindest teilweise aus dem Schaltschrank herausschwenken, um beispielsweise die Zugänglichkeit von rückseitigen Anschlüssen des Einbaumoduls zu verbessern. Nachdem der Installateur die Arbeiten abgeschlossen hat, kann das Einbaumodul wieder vollständig in den Schaltschrank hereingeschwenkt werden und der Schaltschrank durch Schließen einer Schaltschranktür verschlossen werden.

In dem Patent DE 10 2016 110 066 B3 wird beispielsweise ein Systemschrank mit einer darin verbauten Kühleinheit ("cooling unit") beschrieben, die zur Vereinfachung von Wartung und Installation um eine Drehachse herum nach vorne geschwenkt werden kann.

Die chinesische Gebrauchsmusteranmeldung CN 219 478 375 U beschreibt einen Schaltschrank mit Einbauten, die mittels Rollen in waagrechten bzw. senkrecht nach unten verlaufenden Schienen geführt sind und zu Wartungszwecken herausgezogen und um 90° verschwenkt werden können, um deren rückseitige Zugänglichkeit zu verbessern.

Vor diesem Hintergrund liegt der vorliegenden Erfindung die Aufgabe zugrunde, einen Schaltschrank der eingangs beschriebenen Art bereitzustellen, der sich durch eine verbesserte Praxistauglichkeit auszeichnet, insbesondere im Hinblick auf eine effiziente Ausnutzung des im Schaltschrank zur Verfügung gestellten Raums, im Hinblick auf eine Erhöhung der Arbeitssicherheit sowie im Hinblick auf kompakte Abmessungen auch im ausgeschwenkten Zustand bei gleichzeitig ausreichender Zugänglichkeit der Rückseite des Einbaumoduls. Gelöst wird diese Aufgabe durch den erfindungsgemäßen Schaltschrank gemäß Anspruch 1. Besonders vorteilhafte Ausführungsformen sind den abhängigen Ansprüchen zu entnehmen.

Der erfindungsgemäße Schaltschrank zur Aufnahme eines (elektronischen oder elektrischen) Einbaumoduls umfasst

- einen Schrankrahmen, der von einer frontseitigen Rahmenebene sowie einer rückseitigen (insbesondere ebenen) Rahmenfläche begrenzt ist,
- eine fest mit dem Schrankrahmen verbundene Schienenanordnung,
- eine zur Aufnahme des Einbaumoduls geeignete Schwenkvorrichtung mit Führungselementen, die entlang der Schienenanordnung verschiebbar sind,
  wobei
- die Schwenkvorrichtung in einem eingeschwenkten Zustand vollständig in den Schrankrahmen eingeschwenkt ist und die Schwenkvorrichtung durch Schwenken in einen ausgeschwenkten Zustand bringbar ist, in dem die Schwenkvorrichtung teilweise durch die frontseitige Rahmenebene aus dem Schrankrahmen herausragt,
- die Schienenanordnung einen horizontal verlaufenden Tragschienenabschnitt und einen oberhalb des Tragschienenabschnitts angeordneten, diagonal verlaufenden Führungsschienenabschnitt aufweist,
- beim Schwenken der Schwenkvorrichtung vom eingeschwenkten in den ausgeschwenkten Zustand, sich ein erstes der Führungselemente der Schwenkvorrichtung entlang des horizontal verlaufenden Tragschienenabschnitts verschiebt und sich ein zweites der Führungselemente der Schwenkvorrichtung entlang des diagonal verlaufenden Führungsschienenabschnitts verschiebt.

Die Erfindung basiert auf der Erkenntnis, dass sich durch die synergetische Kombination der erfindungsgemäßen Merkmale, insbesondere durch Kombination eines horizontalen Tragschienenabschnitts, eines diagonalen Führungsschienenabschnitts und darin verschiebbar gelagerten Führungselementen, ein Schwenkmechanismus realisieren lässt, der sich durch eine Reihe von Vorteilen auszeichnet:

Stabile Position im eingeschwenkten Zustand

Erfindungsgemäß kann eine Schwenkvorrichtung realisiert werden, die sich im eingeschwenkten Zustand in einer stabilen Position befindet. Denn um die Schwenkvorrichtung herauszuschwenken, muss ihr Schwerpunkt, bedingt durch die Anordnung der Schienenabschnitte, zunächst etwas angehoben werden. Die Gewichtskraft der Schwenkvorrichtung wirkt dem Herausschwenken aus dem eingeschwenkten Zustand somit (zu Beginn des Schwenkvorgangs) selbsthemmend entgegen, sodass die Schwenkvorrichtung konstruktionsbedingt (relativ) sicher in der eingeschwenkten Position verharrt und nicht unbeabsichtigt herausschwenkt. Auf diese Weise kann verhindert werden, dass ein Monteur durch eine unerwartet herausschwenkende Schwenkvorrichtung überrascht oder sogar verletzt wird, was der Arbeitssicherheit zuträglich ist - insbesondere dann, wenn der Schaltschrank auf einem Schiff zum Einsatz kommt und dort wellen- und seegangbedingt ständigen Bewegungen ausgesetzt ist.

Kompakte Abmessung auch im ausgeschwenkten Zustand

Durch die Ausgestaltung und Positionierung der diagonal verlaufenden Führungsschiene kann beeinflusst werden, wie weit die Schwenkvorrichtung im ausgeschwenkten Zustand über die frontseitige Rahmenebene hinausragt. Die dadurch ermöglichte Begrenzung des frontseitigen Herausragens der Schwenkvorrichtung kann insbesondere dann vorteilhaft sein, wenn der Schaltschrank unter engen Platzverhältnissen zum Einsatz kommt und auch unter diesen Bedingungen ein Herausschwenken der Schwenkvorrichtung ermöglicht werden soll.
Weiterhin hat das geringe Herausragen der Schwenkvorrichtung im ausgeschwenkten Zustand den Vorteil, dass sich der Schwerpunkt der Schwenkvorrichtung selbst im ausgeschwenkten Zustand innerhalb (oder zumindest nicht allzu weit außerhalb) des Schrankrahmens befindet, was dem stabilen Stand des Schaltschranks zuträglich und einem Umkippen des Schaltschranks abträglich ist.
Durch das erfindungsgemäße Zusammenspiel von Führungselementen, Führungsschienenabschnitt und Tragschienenabschnitt wird erreicht, dass sich die Schwenkachse, um die die Schwenkvorrichtung herumgeschwenkt wird, während des Schwenkvorgangs entlang des Tragschienenabschnitts verschiebt. Wird die Schwenkvorrichtung aus dem eingeschwenkten Zustand herausgeschwenkt, befindet sich die Schwenkachse zunächst nahe der frontseitigen Rahmenebene des Schaltschranks. Kurz bevor der ausgeschwenkte Zustand erreicht wird, befindet sich die Schwenkachse weiter im Inneren des Schrankrahmens.

Effiziente Raumausnutzung

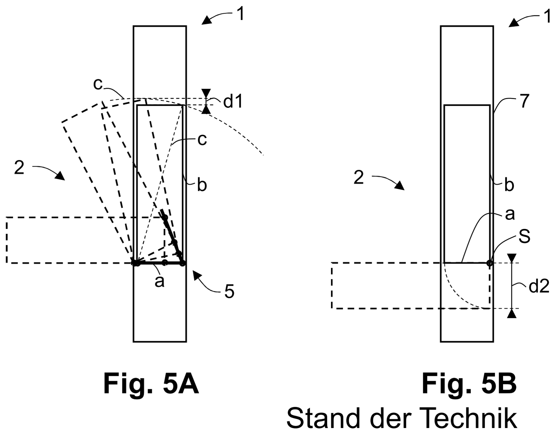

Wenn eine Schwenkvorrichtung in einem Schaltschrank vorgesehen ist, muss typischerweise ein gewisser Abstandsbereich im Schaltschrank vorgesehen und freigehalten werden, damit die Schwenkvorrichtung beim Aus- und Einschwenken nicht mit dort angeordneten Komponenten kollidiert.
Die Erfinder haben nun erkannt, dass sich durch die erfindungsgemäße Lagerung der Schwenkvorrichtung mittels der Führungselemente in der Schienenanordnung der vorzuhaltende Abstandsbereich geometriebedingt kleiner gewählt werden kann als bei einer herkömmlichen Positionierung der Schwenkachse nahe der rückseitigen Rahmenfläche des Schaltschranks.
Um diesen Zusammenhang zu illustrieren, ist in den Figuren 5A und 5B jeweils ein Schaltschrank 1 mit einer Schwenkvorrichtung 2 mit den Kantenlängen a und b skizziert.
Beim erfindungsgemäßen Schaltschrank gemäß Fig. 5A ist die Schwenkvorrichtung 2 mittels eines ersten Führungselements 3.1 im Tragschienenabschnitt 4 der Schienenanordnung 5 und mittels eines zweiten Führungselements 3.2 im Führungsschienenabschnitt 6 der Schienenanordnung 5 beweglich gelagert.
Beim vorbekannten Schaltschrank 1 gemäß Figur 5B hingegen ist die Schwenkvorrichtung 2 drehbar um eine (ortsfeste) Schwenkachse S im Schrankrahmen gelagert, wobei die Schwenkachse S nahe der hinteren Rahmenebene 7 angeordnet ist.
Durchgezogene Linien zeigen die Schwenkvorrichtung 2 jeweils im eingeschwenkten Zustand (eingeschwenkte Position), gestrichelte Linien im ausgeschwenkten Zustand (ausgeschwenkte Position) bzw. in einem Zwischenzustand.
Die Mindesthöhe der vorzusehenden Abstandsbereiche d1, d2 können mittels trigonometrischer Betrachtungen bestimmt werden:

Gemäß Fig. 5A beträgt die Mindesthöhe des Abstandbereichs $d_1 = c - b = \sqrt{a^2 + b^2} - b$, wobei die Länge der Diagonalen c, des durch die Kanten a und b aufgespannten Rechtecks, gemäß Pythagoras $c = \sqrt{a^2 + b^2}$ beträgt.

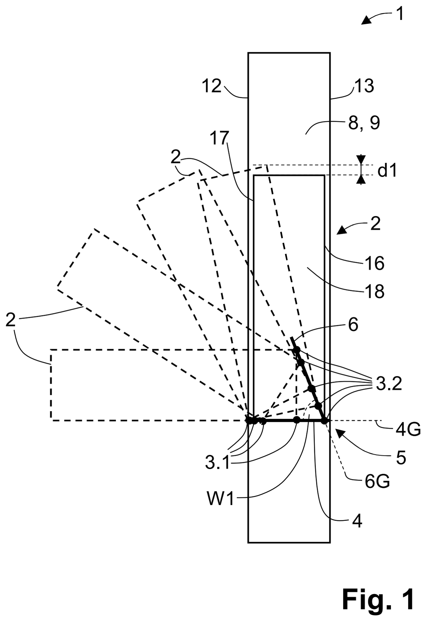

Gemäß Fig. 1B beträgt die Mindesthöhe des Abstandbereichs d2 hingegen a.

Dabei lässt sich mathematisch beweisen, dass für alle Kantenlängen a, b (größer 0) gilt, dass die Mindesthöhe des Abstandsbereichs d1 des erfindungsgemäßen Schaltschranks gemäß Figur 5A kleiner ist als die Mindesthöhe des Abstandbereichs d2 des Schaltschranks gemäß Figur 5B.

Die Erfindung ermöglicht somit die Realisierung eines besonders kleinen Abstandbereichs. Auf diese Weise muss nur sehr wenig Volumen (Raum) im Schaltschrank freigehalten werden, um ein problemloses Schwenken der Schwenkvorrichtung zu ermöglichen, wodurch der im Schaltschrank vorhandene Raum besonders effizient ausnutzbar ist.

Zugänglichkeit der Rückseite des Einbaumoduls

Gleichzeitig ermöglicht der erfindungsgemäße Schaltschrank im ausgeschwenkten Zustand eine besondere einfache Zugänglichkeit der Rückseite der Schwenkvorrichtung, da sich beim Herausschwenken ein relativ großer Abstand zwischen der Rückseite der Schwenkvorrichtung und der rückseitigen Rahmenfläche auftut, der dem Installateur den rückseitigen Zugriff auf die Schwenkvorrichtung (bzw. das darin aufgenommene Einbaugerät) erleichtert.

Im Folgenden werden einige Begriffe und Aspekte der Erfindung detaillierter erläutert und definiert:
Eine (Rahmen-)Ebene ist vorliegend dadurch definiert, dass die Verbindungsgerade zweier beliebiger Punkte der (Rahmen-)Ebene selbst wieder in der (Rahmen-)Ebene liegt.

Eine (Rahmen-)Fläche hingegen kann auch gewölbt sein. Bei den meisten Anwendungsfällen ist die rückseitige Rahmenfläche des Schaltschranks zwar eben, sodass es sich demnach um eine rückseitige Rahmenebene handelt, die insbesondere parallel zur frontseitigen Rahmenebene verläuft. In besonderen Anwendungsfällen hingegen, insbesondere wenn der Schaltschrank in einem Raum mit nicht-ebenen Wänden installiert werden soll (wie beispielsweise einem Schiff oder einem Unterseebot), kann es jedoch zweckmäßig sein, den Schrankrahmen derart auszuführen, dass die Schrankrückseite an die Kontur der angrenzenden nicht-ebenen Wand angepasst ist, wodurch sich eine gewölbte rückseitige Rahmenfläche ergeben kann.

Lageangaben wie beispielsweise horizontal, vertikal, oben, oberhalb, unten und unterhalb beziehen sich auf die (auch in den Figuren dargestellte) bestimmungsgemäße Einbaulage des Schaltschranks.

Das erste Führungselement ist entlang des horizontal verlaufenden Tragschienenabschnitts von einer (mit dem eingeschwenkten Zustand korrespondierenden) ersten Position in eine (mit dem ausgeschwenkten Zustand korrespondierenden) zweite Position verschiebbar. Unter einem horizontal verlaufenden Tragschienenabschnitt ist ein Tragschienenabschnitt zu verstehen, bei dem eine die erste Position mit der zweiten Position verbindende Gerade, die Tragschienen-Verbindungsgerade, horizontal verläuft.

Unter einer horizontal verlaufenden (Tragschienen-) Verbindungsgerade wird vorliegend eine Verbindungsgerade verstanden, die bei einem bestimmungsgemäß ausgerichteten Schaltschrank mit der Horizontebene einen Winkel von weniger als 20°, insbesondere weniger als 10° oder 5°, einschließt. Die Horizontebene steht dabei im rechten Winkel zur Lotrichtung, also der Richtung der Gravitationskraft, am Standort des Schaltschranks.

Der Weg zwischen der ersten Position und der zweiten Position, entlang dem das erste Führungselement beim Schwenken der Schwenkvorrichtung verschoben wird, verläuft bei einem geraden Tragschienenabschnitt entlang der (Tragschienen-) Verbindungsgerade. Es sind aber auch Schienenabschnitte denkbar, bei denen der Weg z.B. bogenförmig, kurvenförmig oder gewellt verläuft.

Das zweite Führungselement ist entlang des diagonal verlaufenden Führungsschienenabschnitts von einer (mit dem eingeschwenkten Zustand korrespondierenden) ersten Position in eine (mit dem ausgeschwenkten Zustand korrespondierenden) zweite Position verschiebbar. Unter einem diagonal verlaufenden Führungsschienenabschnitt ist ein Führungsschienenabschnitt zu verstehen, bei dem eine die erste Position mit der zweiten Position verbindende Gerade, die Führungsschienen-Verbindungsgerade, diagonal verläuft.

Unter einer diagonal verlaufenden (Führungsschienen-) Verbindungsgerade wird vorliegend eine Verbindungsgerade verstanden, die mit der Horizontalebene einen Winkel von mehr als 20° und weniger als 80°, insbesondere einen Winkel von mehr als 30° und weniger als 70° oder einen Winkel von mehr als 40° und weniger als 60°, einschließt.

Der Weg zwischen der ersten Position und der zweiten Position, entlang dem das zweite Führungselement beim Schwenken der Schwenkvorrichtung verschoben wird, verläuft bei einem geraden Schienenabschnitt entlang der Verbindungsgerade. Es sind aber auch Schienenabschnitte denkbar, bei denen der Weg z.B. bogenförmig, kurvenförmig oder gewellt verläuft.

Mit der Formulierung, dass der diagonal verlaufende Führungsschienenabschnitt "oberhalb" des horizontal verlaufenden Tragschienenabschnitts angeordnet ist, kommt zum Ausdruck, dass sich zumindest ein Großteil des sich zwischen der ersten und der zweiten Position erstreckenden Abschnitts der Führungsschienen-Verbindungsgerade oberhalb der Tragschienen-Verbindungsgerade erstreckt. Zumindest befindet sich das zweite Führungselement in seiner zweiten Position oberhalb der Tragschienen-Verbindungsgerade.

Bevorzugt sind der Tragschienenabschnitt und der Führungsschienenabschnitt als gerade Schienenabschnitte ausgeführt und schließen miteinander einen spitzen Winkel ein, der zur frontseitigen Rahmenebene hin geöffnet ist und insbesondere zwischen 30° und 80° oder zwischen 60° und 80° beträgt.

Gerade Schienenabschnitte sind besonders kostengünstig herstellbar und einfach in einen erfindungsgemäßen Schaltschrank zu integrieren.

Der Winkel, den die beiden Schienenabschnitte miteinander einschließen, bestimmt darüber, wie weit die Schwenkvorrichtung im ausgeschwenkten Zustand über die frontseitige Rahmenebene herausragt und wie groß in diesem Zustand der Abstand zwischen der Rückseite der Schwenkvorrichtung und der rückseitigen Rahmenfläche ist. Die Anordnung der beiden Schienenabschnitte im spitzen Winkel, insbesondere in einem Winkel zwischen 30° und 80°, hat sich dabei als besonders praktikable Lösung herauskristallisiert, die eine bequeme Zugänglichkeit der Rückseite der Schwenkvorrichtung ermöglicht, ohne dass die Schwenkvorrichtung zu weit über die frontseitige Rahmenebene herausragt.

Gemäß einer weiteren bevorzugten Ausführungsform der Erfindung sind die Führungselemente als Führungsrollen ausgeführt.

Auf diese Weise können die Führungselemente besonders reibungs- und geräuscharm entlang der Schienenanordnung verschoben werden, wodurch sich ein sehr leichtgängiger Schwenkvorgang realisieren lässt.

Weiterhin kann vorgesehen sein, dass beim Schwenken der Schwenkvorrichtung vom eingeschwenkten Zustand in den ausgeschwenkten Zustand, das erste Führungselement nicht entlang des diagonal verlaufenden Führungsschienenabschnitts bewegt wird.

Erfindungsgemäß ist nach Anspruch 1 vorgesehen, dass sich beim Schwenken der Schwenkvorrichtung das erste Führungselement entlang des Tragschienenabschnitts und das zweite Führungselement entlang des Führungsschienenabschnitts bewegt. Jedem Führungselement ist auf diese Weise ein eigener Schienenabschnitt zugewiesen. Der Weg, den die Führungselemente beim Schwenken zwischen der jeweiligen ersten und zweiten Position zurücklegen, kann somit durch die Gestaltung des jeweiligen Schienenabschnitts individuell festgelegt werden, wodurch die gewünschte Schwenkbewegung der Schwenkvorrichtung resultiert. Durch den vorliegenden Unteranspruch wird nochmals ausdrücklich klargestellt, dass sich beim Schwenken das erste Führungselement nicht entlang des Führungsschienenabschnitts, sondern entlang des Tragschienenabschnitts bewegt.

Gemäß einer weiteren vorteilhaften Ausführungsform des erfindungsgemäßen Schaltschranks ragt im ausgeschwenkten Zustand die Schwenkvorrichtung bezüglich ihrer horizontalen Erstreckung zu weniger als einem Drittel, insbesondere zu weniger als einem Viertel oder einem Fünftel, über die frontseitige Rahmenebene hinaus.

Auf diese Weise kann ein Schaltschrank realisiert werden, der auch unter beengten Platzverhältnissen, wenn nur begrenzt Raum frontseitig vor dem Schaltschrank zur Verfügung steht, eingesetzt werden kann. Die Positionierung des Führungsschienenabschnitts innerhalb des Schrankrahmens und der Winkel, den die Führungsschienen-Verbindungsgerade mit der Horizontalebene einschließt, entscheiden dabei darüber, wie weit die Schwenkvorrichtung im ausgeschwenkten Zustand über die frontseitige Rahmenebene herausragt.

Bevorzugt ist der Schaltschrank spiegelsymmetrisch zu einer lotrecht verlaufenden Spiegelebene ausgeführt, sodass auch die Schienenanordnung und die Schwenkvorrichtung mitsamt ihren Führungselementen ebenfalls spiegelsymmetrisch ausgeführt ist.

Weiterhin kann vorgesehen sein, dass der Schaltschrank mindestens zwei Schienenanordnungen und zwei Schwenkvorrichtungen aufweist.

Die beiden Schwenkvorrichtungen können dabei insbesondere horizontal nebeneinander oder vertikal untereinander angeordnet sein.

Gemäß einer weiteren vorteilhaften Ausführungsform der Erfindung kann vorgesehen sein, dass der Schaltschrank eine (insbesondere eine Gasdruckfeder umfassende) Dämpfungsvorrichtung aufweist.

Auf diese Weise kann das Schwenken der Schwenkvorrichtung für den Monteur erleichtert werden, da die Dämpfungsvorrichtung einen Teil der Kraft aufbringt, mit der die Schwenkvorrichtung während des Schwenkens gestützt wird. Somit kann der Monteur entlastet und ein ungebremstes Herausschwenken der Schwenkvorrichtung verhindert werden.

Nachfolgend sind einige Ausführungsbeispiele des erfindungsgemäßen Schaltschranks anhand der Abbildungen näher erläutert. Dabei zeigt

Fig. 1          einen erfindungsgemäßen Schaltschrank in mehreren Schwenkpositionen in einer schematischen Seitenansicht,

Fig. 2A & 2B     einen erfindungsgemäßen Schaltschrank im eingeschwenkten Zustand (Fig. 2A) und im ausgeschwenkten Zustand (Fig. 2B), jeweils in einer perspektivischen Schrägansicht,

Fig. 3A & 3B     den Schaltschrank gemäß Fig. 2A & 2B im eingeschwenkten Zustand (Fig. 3A) und im ausgeschwenkten Zustand (Fig. 3B), jeweils in einer Front- und Seitenansicht,

Fig. 4A & 4B     einen vergrößerten Teilausschnitt des Schaltschranks gemäß den Figuren 2A bis 3B im eingeschwenkten Zustand (Fig. 4A) und im ausgeschwenkten Zustand (Fig. 4B), jeweils in einer Seitenansicht, und

Fig. 5A & 5B   eine schematische Gegenüberstellung des erfindungsgemäßen Schaltschranks gemäß Fig. 1 und eines Schaltschranks gemäß dem Stand der Technik.

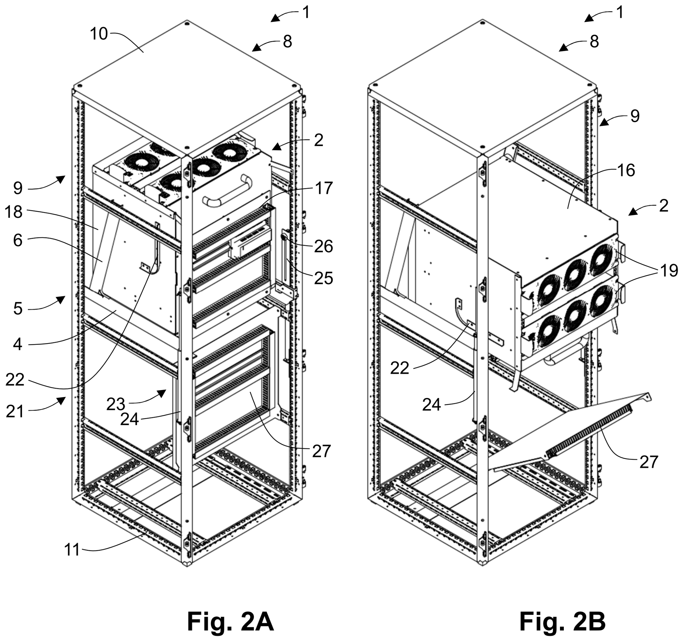

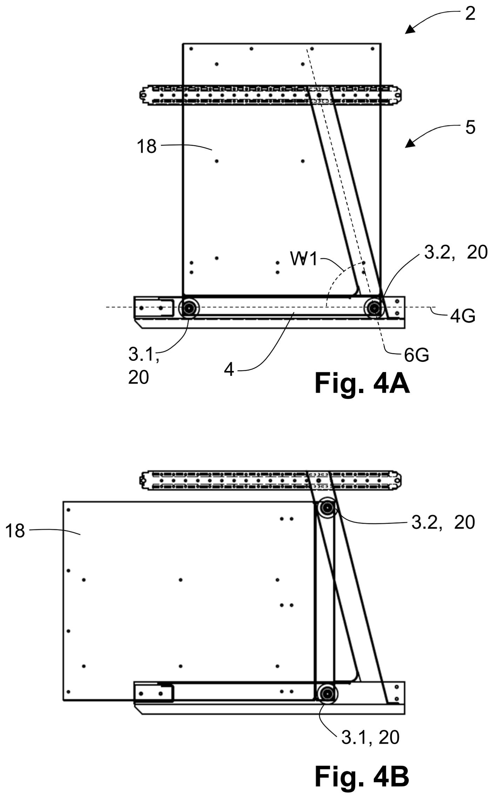

Der allgemeine Aufbau sowie der Schwenkvorgang des erfindungsgemäßen Schaltschranks 1 wird vorwiegend mit Blick auf die Figur 1 näher erläutert, mit Verweis auf die Ausführungsform gemäß den Figuren 2A bis 4B wird auf konstruktive Details eingegangen.

Der erfindungsgemäße Schaltschrank 1 weist einen Schrankrahmen 8, eine Schienenanordnung 5 und eine Schwenkvorrichtung 2 auf.

Der quaderförmige Schrankrahmen 8 umfasst zwei Schrankrahmenseiten 9, einen Schrankrahmendeckel 10 sowie einen Schrankrahmenboden 11 und wird von der frontseitigen Rahmenebene 12 und der ebenfalls ebenen rückseitigen Rahmenfläche 13 (rückseitige Rahmenebene) begrenzt. Bei der in Figur 2A bis 4B dargestellten Ausführungsform sind die Schrankrahmenseiten 9 und der Schrankrahmenboden 11 durch horizontal bzw. vertikal verlaufende Metallleisten 14 ausgeführt, während der Schrankrahmendeckel 10 als Metallblech 15 ausgeführt ist.

Die Schienenanordnung 5 ist durch Verschraubungen fest mit den Schrankrahmenseiten 9 des Schrankrahmens 8 verbunden. Die Schienenanordnung 5 umfasst dabei zwei verschiedene, jeweils gerade Schienenabschnitte 4, 6: einen horizontal verlaufenden Tragschienenabschnitt 4 und einen oberhalb des Tragschienenabschnitts 4 angeordneten, diagonal verlaufenen Führungsschienenabschnitt 6. Die beiden geraden Schienenabschnitte 4, 6 schließen miteinander einen spitzen Winkel W1 ein, der zur frontseitigen Rahmenebene 12 hin geöffnet ist und gemäß Figur 1 etwa 70° (+/- 5°) und gemäß den Figuren 2A bis 4B etwa 76° (+/- 5°) beträgt.

Die Schwenkvorrichtung 2 umfasst eine Rückseite 16, eine Vorderseite 17 sowie zwei Seitenteile 18, zwischen denen zwei Einbaumodule 19 aufgenommen sind (wie in den Figuren 2A bis 4B dargestellt) bzw. mindestens ein Einbaumodul 19 aufgenommen werden kann.

An den Seitenteilen 18 sind jeweils zwei als Führungsrollen 20 ausgeführte Führungselemente 3.1, 3.2 angeordnet, die in den Schienenabschnitten 4, 6 der Schienenanordnung 5 geführt und damit entlang der Schienenanordnung 5 verschoben werden können. Ein erstes der beiden Führungselemente 3.1 ist dabei entlang des horizontalen Tragschienenabschnitts 4 verschiebbar, ein zweites der beiden Führungselemente 3.2 entlang des diagonalen Führungsschienenabschnitts 6.

Die Schwenkvorrichtung 2 kann von einem eingeschwenkten Zustand in einen ausgeschwenkten Zustand (und wieder zurück) geschwenkt werden. Figur 1 zeigt die Schwenkvorrichtung 2 mit durchgezogenen Linien im eingeschwenkten Zustand und mit gestrichelten Linien im ausgeschwenkten Zustand sowie in drei Zwischenzuständen während des Herausschwenkens.

Im eingeschwenkten Zustand, der insbesondere in den Figuren 2A, 3A und 4A dargestellt ist, befindet sich die Schwenkvorrichtung 2 vollständig im Schrankrahmen 8 und ist somit vollständig in diesen eingeschwenkt. In diesem Zustand befindet sich das erste Führungselement 3.1 an seiner ersten Position innerhalb des Tragschienenabschnitts 4, das zweite Führungselement 3.2 befindet sich an seiner ersten Position innerhalb des Führungsschienenabschnitts 6.

Im ausgeschwenkten Zustand, der insbesondere in den Figuren 2B, 3B und 4B dargestellt ist, ragt die Schwenkvorrichtung 2 teilweise durch die frontseitige Rahmenebene 12 aus dem Schrankrahmen 8 heraus. In den im vorstehenden Satz erwähnten Darstellungen ragt die Schwenkvorrichtung 2 bezüglich ihrer horizontalen Erstreckung etwa zu einem Viertel über die frontseitige Rahmenebene 12 hinaus. In diesem Zustand befindet sich das erste Führungselement 3.1 an seiner zweiten Position innerhalb des Tragschienenabschnitts, das zweite Führungselement 3.2 befindet sich an seiner zweiten Position innerhalb des Führungsschienenabschnitts 6.

Beim Schwenken wird das erste Führungselement 3.1 entlang einer horizontal verlaufenden Tragschienen-Verbindungsgerade 4G zwischen seiner ersten und zweiten Position bewegt, das zweite Führungselement 3.2 wird entlang einer diagonal verlaufenden Führungsschienen-Verbindungsgerade 6G zwischen seiner ersten und zweiten Position bewegt.

Somit bewegt sich beim Schwenken der Schwenkvorrichtung 2 das erste Führungselement 3.1 entlang des Tragschienenabschnitts 4 und das zweite Führungselement 3.2 entlang des Führungsschienenabschnitts 6. Jedem Führungselement 3.1, 3.2 ist auf diese Weise ein eigener Schienenabschnitt 4, 6 zugewiesen.

In den Figuren 2A bis 3B ist erkennbar, dass an der Vorderseite der Schwenkvorrichtung 2 ein Griff angeordnet ist, an dem der Monteur die Schwenkvorrichtung 2 zum Heraus- bzw. Hereinschwenken bequem greifen kann.

Der Schaltschrank 1 gemäß den Figuren 2A bis 3B weist zudem zwei beidseitig der Schwenkvorrichtung 2 angeordnete Dämpfungsvorrichtungen 21 mit jeweils einer Dämpfungsschiene 22 und einer Dämpfungseinheit 23 auf. Die L-förmigen, abgerundeten Dämpfungsschienen 22 sind mit den gegenüberliegenden Seitenteilen 18 der Schwenkvorrichtung 2 mittels Schrauben fest verbunden (siehe hierzu Figuren 2A und 2B).

Die Dämpfungseinheiten 23 umfassen jeweils eine Gasdruckfeder 24, eine Linearführung 25 und eine Dämpfungsrolle 26. Die unteren Enden der Gasdruckfedern 24 sind jeweils fest mit einer der beiden gegenüberliegenden Schrankrahmenseiten 9 verbunden. Die oberen Enden der Gasdruckfedern 24 hingegen sind entlang der Linearführungen 25 vertikal verschiebbar und tragen die Dämpfungsrollen 26. Im eingeschwenkten Zustand der Schwenkvorrichtung 2 sind die Gasdruckfedern 24 expandiert, sodass sich die Dämpfungsrollen 26 ganz oben in den Linearführungen 25 befinden.

Wird die Schwenkvorrichtung 2 nun vom eingeschwenkten Zustand in den ausgeschwenkten Zustand herausgeschwenkt, treten die Dämpfungsschienen 22 mit den Dämpfungsrollen 26 in Kontakt. Dabei wird ein Teil der Gewichtskraft der Schwenkvorrichtung 2 in die Gasdruckfedern 24 eingeleitet, woraufhin diese unter Abbremsung des Schwenkvorgangs zusammengedrückt und die Dämpfungsrollen 26 entlang der Linearführung 25 nach untern verschoben werden. Die Dämpfungsrollen 26 rollen dabei auf den Dämpfungsschienen 22 ab.

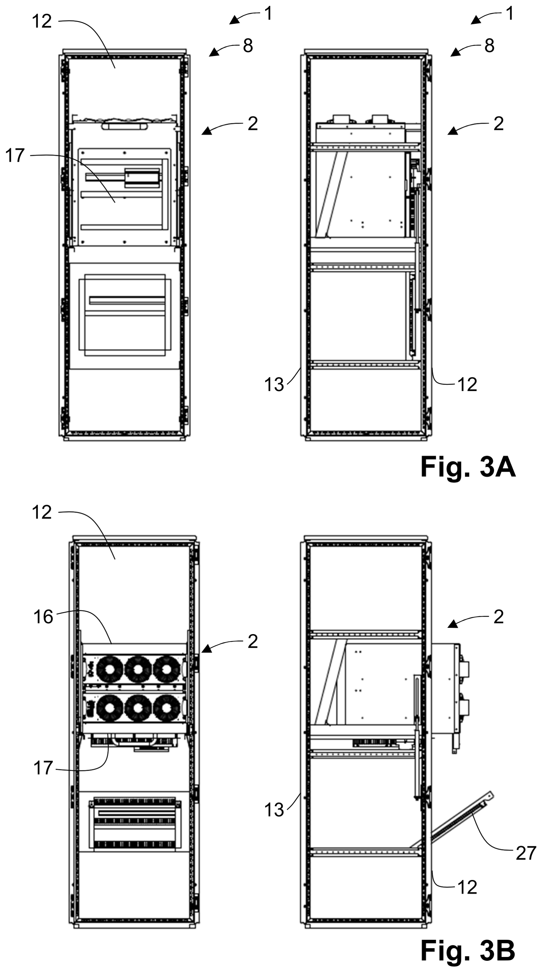

In einem Bereich des Schaltschranks 1 unterhalb der Schwenkvorrichtung 2 ist eine drehbar am Schrankrahmen 8 gelagerte Blende 27 angeordnet, die in den Figuren 2A und 3A in einem eingeschwenkten und in den Figuren 2B und 3B in einem ausgeschwenkten Zustand dargestellt ist.

Bezugszeichenliste

| | |
|---|---|
| Schaltschrank | 1 |
| Schwenkvorrichtung | 2 |
| erstes Führungselement | 3.1 |
| zweites Führungselement | 3.2 |
| Tragschienenabschnitt | 4 |
| Tragschienen-Verbindungsgerade | 4G |
| Schienenanordnung | 5 |
| Führungsschienenabschnitt | 6 |
| Führungsschienen-Verbindungsgerade | 6G |
| hinteren Rahmenebene | 7 |
| Schrankrahmen | 8 |
| Schrankrahmenseite | 9 |
| Schrankrahmendeckel | 10 |
| Schrankrahmenboden | 11 |
| frontseitige Rahmenebene | 12 |
| rückseitigen Rahmenfläche | 13 |
| Metallleisten | 14 |
| Metallblech | 15 |
| Rückseite | 16 |
| Vorderseite | 17 |
| Seitenteil | 18 |
| Einbaumodul | 19 |
| Führungsrolle | 20 |
| Dämpfungsvorrichtungen | 21 |
| Dämpfungsschiene | 22 |
| Dämpfungseinheit | 23 |
| Gasdruckfeder | 24 |
| Linearführung | 25 |
| Dämpfungsrolle | 26 |
| Blende | 27 |
| Abstandsbereiche | d1, d2 |
| Schwenkachse | S |
| Winkel | W1 |

**Patentansprüche**

1. Schaltschrank (1) zur Aufnahme eines Einbaumoduls (19) umfassend

- einen Schrankrahmen (8), der von einer frontseitigen Rahmenebene (12) sowie einer rückseitigen Rahmenfläche (13) begrenzt ist,
- eine fest mit dem Schrankrahmen (8) verbundene Schienenanordnung (5),
- eine zur Aufnahme des Einbaumoduls (19) geeignete Schwenkvorrichtung (2) mit Führungselementen (3.1, 3.2), die entlang der Schienenanordnung (5) verschiebbar sind,
wobei
- die Schwenkvorrichtung (2) in einem eingeschwenkten Zustand vollständig in den Schrankrahmen (8) eingeschwenkt ist und die Schwenkvorrichtung (2) durch Schwenken in einen ausgeschwenkten Zustand bringbar ist, in dem die Schwenkvorrichtung (2) teilweise durch die frontseitige Rahmenebene (12) aus dem Schrankrahmen (8) herausragt,
- die Schienenanordnung (5) einen horizontal verlaufenden Tragschienenabschnitt (4) und einen oberhalb des Tragschienenabschnitts (4) angeordneten, diagonal verlaufenden Führungsschienenabschnitt (6) aufweist,
- beim Schwenken der Schwenkvorrichtung (2) vom eingeschwenkten in den ausgeschwenkten Zustand, sich ein erstes (3.1) der Führungselemente der Schwenkvorrichtung (2) entlang des horizontal verlaufenden Tragschienenabschnitts (4) verschiebt und sich ein zweites (3.2) der Führungselemente der Schwenkvorrichtung (2) entlang des diagonal verlaufenden Führungsschienenabschnitts (6) verschiebt.

2. Schaltschrank (1) nach Anspruch 1, wobei der Tragschienenabschnitt (4) und der Führungsschienenabschnitt (6) als gerade Schienenabschnitte ausgeführt sind und miteinander einen spitzen Winkel (W1) einschließen, der zur frontseitigen Rahmenebene (12) hin geöffnet ist und insbesondere zwischen 30° und 80° oder zwischen 60° und 80° beträgt.

3. Schaltschrank (1) nach einem der voranstehenden Ansprüche, wobei die Führungselemente (3.1, 3.2) als Führungsrollen (20) ausgeführt sind.

4. Schaltschrank (1) nach einem der voranstehenden Ansprüche, wobei beim Schwenken der Schwenkvorrichtung (2) vom eingeschwenkten Zustand in den ausgeschwenkten Zustand, das erste Führungselement (3.1) nicht entlang des diagonal verlaufenden Führungsschienenabschnitts (6) bewegt wird.

5. Schaltschrank (1) nach einem der voranstehenden Ansprüche, wobei im ausgeschwenkten Zustand die Schwenkvorrichtung (2) bezüglich ihrer horizontalen Erstreckung zu weniger als einem Drittel, insbesondere zu weniger als einem Viertel oder einem Fünftel, über die frontseitige Rahmenebene (12) hinausragt.

6. Schaltschrank (1) nach einem der voranstehenden Ansprüche, wobei der Schaltschrank (1) mindestens zwei Schienenanordnungen (5) und zwei Schwenkvorrichtungen (2) aufweist.

7. Schaltschrank nach einem der voranstehenden Ansprüche, wobei der Schaltschrank eine, insbesondere eine Gasdruckfeder (24) umfassende, Dämpfungsvorrichtung (21) aufweist.

**Fig. 1**

**Fig. 2A**

**Fig. 2B**

**Fig. 3A**

**Fig. 3B**

2

5

18

W1

3.2, 20

4G

3.1,
20

4

6G

**Fig. 4A**

18

3.2, 20

3.1, 20

**Fig. 4B**

**Fig. 5A**

**Fig. 5B**
Stand der Technik

## EUROPÄISCHER RECHERCHENBERICHT

Nummer der Anmeldung

EP 25 22 2451

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 406 452 A (UCHIUMI HIROSHI [JP]) 11. April 1995 (1995-04-11) * Spalte 2, Zeile 8 - Spalte 4, Zeile 23; Abbildungen 1-5 * ----- | 1-7 | INV. H05K7/16 |
| A | US 2015/008810 A1 (IVEY JOHNATHAN LOYD [US] ET AL) 8. Januar 2015 (2015-01-08) * das ganze Dokument * ----- | 1-7 | |

RECHERCHIERTE SACHGEBIETE (IPC)

H05K

Der vorliegende Recherchenbericht wurde für alle Patentansprüche erstellt

| Recherchenort | Abschlußdatum der Recherche | Prüfer |
|---|---|---|
| Den Haag | 8. April 2026 | Kaluza, Andreas |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
.......................................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 22 2451

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-04-2026

| Im Recherchenbericht angeführtes Patentdokument | Datum der Veröffentlichung | Mitglied(er) der Patentfamilie | Datum der Veröffentlichung |
|---|---|---|---|
| US 5406452 A | 11-04-1995 | JP H05259665 A<br>US 5406452 A | 08-10-1993<br>11-04-1995 |
| US 2015008810 A1 | 08-01-2015 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016110066 B3

- CN 219478375 U